# EUROPÄISCHE PATENTSCHRIFT

(11) **EP 1 855 510 B1**
(45) Veröffentlichungstag und Bekanntmachung des Hinweises auf die Patenterteilung: **22.07.2009**
(21) Anmeldenummer: 06009843.1
(22) Anmeldetag: 12.05.2006
(51) Int. Cl.: H05K 1/03, H05K 3/00

(54) **Flexibles Schichtsystem**
Flexible layer system
Système de couches souple

(43) Veröffentlichungstag der Anmeldung: 14.11.2007
(73) Patentinhaber: Delphi Technologies, Inc., Troy, Michigan 48007 (US); August Krempel Söhne GmbH + Co. KG, 71665 Vaihingen/Enz (DE)
(72) Erfinder: Neumann, Ludwig, 14542 Werder (DE); Brust, Karlheinz, 71665 Vaihingen/Enz (DE); Böhm, Frank, 71665 Vaihingen/Enz (DE)
(74) Vertreter: Denton, Michael John

(56) Entgegenhaltungen:
- EP-A- 1 300 507
- EP-A- 1 553 125
- DE-U1- 20 320 761
- US-A- 4 103 102

## Beschreibung

Die Erfindung betrifft ein flexibles Schichtsystem, insbesondere für eine flexible gedruckte Schaltung, sowie eine flexible Schaltung mit einem derartigen flexiblen Schichtsystem und ein Verfahren zum Herstellen einer solchen flexiblen gedruckten Schaltung.

Flexible gedruckte Schaltungen sind grundsätzlich bekannt und weisen wenigstens eine auf einen flexiblen Träger aufgebrachte elektrische Leiterbahn auf. Bei einer bekannten flexiblen gedruckten Schaltung ist der Träger durch eine Kunststofffolie mit einer Dicke von z.B. etwa 75 µm gebildet. Das Aufbringen der elektrischen Leiterbahn auf die Kunststofffolie erfolgt typischerweise durch Auflaminieren einer Kupferfolie, die anschließend mittels entsprechender Maskierungs- und Ätzprozesse strukturiert wird. Als problematisch erweist sich bei einer derartigen flexiblen gedruckten Schaltung, dass die Kunststofffolie - selbst bei auflaminierter Kupferfolie - leicht einreißen und in der Folge auch durchreißen kann. Dies gilt insbesondere dann, wenn die flexible gedruckte Schaltung umgebogen wird.

Um die Reißfestigkeit einer flexiblen gedruckten Schaltung zu erhöhen, wurde deshalb vorgeschlagen, ein Gewebematerial als Träger zu verwenden. Damit während der Strukturierung einer auf das Gewebematerial auflaminierten Kupferfolie keine Ätzflüssigkeit in das Gewebematerial eindringen und zu einem späteren Zeitpunkt die elektrische Leiterbahn beschädigen kann, wird das Gewebematerial mit einem geeigneten Harzmaterial imprägniert, d.h. vollständig mit dem Harzmaterial durchtränkt. Derartige Verbundkörper, bei denen das Gewebematerial vollständig mit Harzmaterial durchtränkt ist sind, beispielsweise aus der US 4,103,102 A oder aus der DE 203 20 761 U1 bekannt. Dies führt jedoch dazu, dass das Gewebematerial nach dem Aushärten des Harzmaterials steif wird, d.h. also an Flexibilität verliert.

Aus der EP 1 553 125 A1 und aus EP 1 300 507 A2 ist es bekannt, Fasergewebe mit einer mit einem Weichmacher versetzten Harzmatrix zu beschichten, um die Flexibilität des Verbundkörpers an erhalten.

Der Erfindung liegt die Aufgabe zugrunde, ein flexibles Schichtsystem und eine flexible gedruckte Schaltung zu schaffen, welches bzw. welche nicht nur eine besonders hohe Reißfestigkeit, sondern gleichzeitig auch eine besonders Flexibilität aufweist.

Zur Lösung der Aufgabe sind ein flexibles Schichtsystem mit den Merkmalen des Anspruchs 1 sowie eine flexible gedruckte Schaltung mit den Merkmalen des Anspruchs 6 vorgesehen. Weiterer Gegenstand der Erfindung ist außerdem ein Verfahren zum Herstellen einer flexiblen gedruckten Schaltung mit den Merkmalen des Anspruchs 10.

Das erfindungsgemäße flexible Schichtsystem umfasst eine ein Gewebematerial aufweisende Gewebematerialschicht und eine ein Harzmaterial aufweisende Harzmaterialschicht, welche auf eine Oberfläche der Gewebematerialschicht derart aufgebracht ist, dass die Eindringtiefe des Harzmaterials in das Gewebematerial nicht mehr als 80 % der Dicke der Gewebematerialschicht beträgt.

Der Erfindung liegt mit anderen Worten die Idee zugrunde, das Gewebematerial nicht zu imprägnieren, d.h. vollständig mit Harz zu durchtränken, sondern stattdessen lediglich eine Seite der Gewebematerialschicht mit dem Harzmaterial zu beschichten. Da das Harzmaterial beim Aufbringen auf die Gewebematerialschicht eine gewisse Fließfähigkeit aufweist, lässt es sich in der Praxis kaum vermeiden, dass das Harzmaterial beim Aufbringen auf die Gewebematerialschicht auch in das Gewebematerial eindringt. Erfindungsgemäß ist die Eindringtiefe des Harzmaterials in das Gewebematerial aber möglichst gering gehalten, nämlich so, dass sie etwa 80 % der Gesamtdicke der Gewebematerialschicht nicht übersteigt.

Auf diese Weise bleibt nicht nur der stoffliche Charakter, sondern auch die Flexibilität des Gewebematerials zumindest weitgehend erhalten. Darüber hinaus weist das flexible Schichtsystem nicht nur eine besonders hohe Flexibilität, sondern durch die Verwendung des Gewebematerials auch eine besonders gute Reißfestigkeit auf, die durch das auf das Gewebematerial aufgebrachte Harzmaterial zusätzlich erhöht ist.

So zeichnet sich das erfindungsgemäße flexible Schichtsystem durch eine gegenüber herkömmlichen flexiblen gedruckten Schaltungen mit Kunststofffolienträgern etwa zehnmal bessere mechanische Stabilität aus, und das Schichtsystem kann bei einem Verbiegen mit einem Biegeradius von kleiner als 5 mm mehr als 10⁵ Lastwechseln standhalten.

Die Harzmaterialschicht verhindert darüber hinaus nicht nur eine Schrumpfung der Gewebematerialschicht unter Feuchtigkeitseinfluss, sondern auch ein Eindringen von Feuchtigkeit in das Gewebematerial von der Harzseite her. Dadurch ist es möglich, eine Kupferfolie auf die Harzmaterialschicht aufzubringen und mittels eines Maskierungs- und Ätzverfahrens zu strukturieren, ohne dass eine dabei verwendete Ätzflüssigkeit in die Gewebematerialschicht eindringen kann.

Das erfindungsgemäße flexible Schichtsystem ermöglicht mit anderen Worten die Herstellung einer flexiblen gedruckten Schaltung, deren Biegeeigenschaften mit denen einer flexiblen gedruckten Schaltung mit Kunststofffolienträger vergleichbar ist, deren Reißfestigkeit im Vergleich zu der Reißfestigkeit einer flexiblen gedruckten Schaltung mit Kunststofffolienträger jedoch um ein Vielfaches höher ist.

Gemäß einer vorteilhaften Ausführungsform des flexiblen Schichtsystems ist das Harzmaterial in einem auf das Gewebematerial aufgebrachten Vormontagezustand physikalisch trocken, aber noch nicht vollständig vernetzt. Der Zustand "physikalisch trocken" wird auch als "berührtrocken" bezeichnet und bedeutet, dass das Harzmaterial frei von Lösungsmitteln ist. Der Zustand, in dem das Harzmaterial physikalisch trocken, aber noch nicht vollständig vernetzt ist, wird auch als "B-Zustand" oder "B-Stage" bezeichnet. Im Gegensatz zum "B-Zustand" bezeichnet der "A-Zustand" dagegen einen Zustand des Harzmaterials, in welchem das Harzmaterial nicht physikalisch trocken und nicht vernetzt ist, und der "C-Zustand" einen Zustand, in welchem das Harzmaterial sowohl physikalisch trocken als auch vernetzt ist.

Das Harzmaterial ist in dem "B-Zustand" nicht mehr "klebrig" und lässt sich folglich besonders einfach handhaben. Beispielsweise kann das flexible Schichtsystem in diesem Zustand aufgewickelt und an einen Ort transportiert werden, an welchem das Schichtsystem zu einer flexiblen gedruckten Schaltung weiterverarbeitet wird.

Bevorzugt weist das Gewebematerial ein organisches Material auf. Beispielsweise kann das Gewebematerial bzw. können insbesondere die Kettenfäden und/oder die Schussfäden des Gewebematerials Fasern aus einem Polymermaterial, z.B. Poly-Ethylen-Terephthalat (PET) oder Poly-Ethylen-Naphthalat (PEN), oder aus Polyester, Glas, Polyacetat, Polyamid, Polyaramid, Polyphenylensulfid, Polyethersulfon, Polyetherimid, Polyimid oder Polyetheretherketon aufweisen.

Das Gewebematerial der Gewebematerialschicht kann ferner ein Gewicht im Bereich von 50 bis 200 g/m² aufweisen, wobei die Anzahl der Kettenfäden im Bereich von 40 bis 150 und die Anzahl der Schussfäden im Bereich von 20 bis 40 liegen kann.

Dabei sollten die Ketten- und Schussfäden des Gewebematerials in Abhängigkeit von der Art des verwendeten Harzmaterials so eng nebeneinander liegen, dass das Harzmaterial beim Aufbringen auf die Gewebematerialschicht möglichst wenig in das Gewebematerial eindringt.

Zur Verstärkung der Fasern kann die Gewebematerialschicht außerdem ein Vliesmaterial aufweisen.

Die Dicke der Gewebematerialschicht kann weniger als 200 µm aufweisen und z.B. 140 µm betragen. Die Dicke der Harzmaterialschicht kann weniger als 50 µm und z.B. 20 µm betragen.

Das Harzmaterial weist vorteilhafterweise Epoxid, Polyurethan, Polyester, Polyether, Acrylat, Silikon, Polyamid, Phenolharz, Melaminharz, Polysulfid, Kautschuk oder Aminoplast auf.

Vorteilhafterweise ist die Beschaffenheit des Harzmaterials so gewählt, dass es nicht nur eine möglichst hohe Flexibilität, sondern gleichzeitig auch eine maximale Temperaturbeständigkeit erreicht. Auf diese Weise kann das flexible Schichtsystem zumindest kurzzeitig erhöhten Temperaturbeanspruchungen standhalten. Dies ermöglicht die Durchführung selektiver Lötprozesse, z.B. wenn das flexible Schichtsystem als Träger für eine elektrische Leiterbahn einer flexiblen gedruckten Schaltung dient. Darüber hinaus sollte die Beschaffenheit des Harzmaterials so gewählt sein, dass es gegenüber einer erhöhten Luftfeuchtigkeit, von z.B. bis zu 100 %, und gleichzeitig erhöhten Gebrauchstemperaturen, von z.B. bis zu 110°C, beständig ist.

Die erfindungsgemäße gedruckte Schaltung umfasst mindestens ein erstes flexibles Schichtsystem der voranstehend beschriebenen Art und wenigstens eine elektrische Leiterbahn, die auf der Harzmaterialschicht des ersten flexiblen Schichtsystems angeordnet ist. Dabei dient das Harzmaterial nicht nur dazu, das Gewebematerial und die elektrische Leiterbahn hinsichtlich Feuchtigkeit bzw. Flüssigkeit voneinander zu trennen, sondern sie kann auch als Haftmittel bzw. Klebstoff dienen, um die elektrische Leiterbahn an der Gewebematerialschicht zu befestigen. Aufgrund der Verwendung des erfindungsgemäßen flexiblen Schichtsystems weist die flexible gedruckte Schaltung alle durch das erfindungsgemäße flexible Schichtsystem erreichten Vorteile, insbesondere die erhöhte Reißfestigkeit bei besonders guter Flexibilität, auf.

Aufgrund der erhöhten Reißfestigkeit braucht die erfindungsgemäße flexible gedruckte Schaltung nicht mit zusätzlichen Mitteln, wie z.B. Kunststoffsicherungen oder Klebebändern, versehen zu werden, um ein Einreißen der Schaltung zu verhindern. Die erfindungsgemäße flexible gedruckte Schaltung ist daher nicht nur mit einem geringeren wirtschaftlichen Aufwand herstellbar, sondern sie kann aufgrund ihrer erhöhten Reißfestigkeit auch in solchen Bereichen zum Einsatz kommen, die für flexible gedruckte Schaltungen mit Kunststofffolienträgern aufgrund ihrer vergleichsweise geringen Reißfestigkeit bisher ausgeschlossen waren.

Gemäß einer Ausführungsform der flexiblen gedruckten Schaltung ist die Leiterbahn zwischen der Harzmaterialschicht des ersten flexiblen Schichtsystems und der Harzmaterialschicht eines zweiten flexiblen Schichtsystems der voranstehend beschriebenen Art angeordnet. Die Leiterbahn ist mit anderen Worten zwischen zwei erfindungsgemäßen flexiblen Schichtsystemen eingebettet, so dass jeweils eines der Schichtsysteme als Trägerschicht und das jeweils andere Schichtsystem als Deckschicht dient.

Alternativ kann die Leiterbahn zwischen der Harzmaterialschicht des ersten flexiblen Schichtsystems und einer Folie, insbesondere einer Kunststofffolie, angeordnet sein. In diesem Fall dient das Schichtsystem als Trägerschicht und die Kunststofffolie als Deckschicht, oder umgekehrt.

Bevorzugt ist das Harzmaterial physikalisch trocken und zumindest annähernd vollständig vernetzt. Das Harzmaterial befindet sich mit anderen Worten im sogenannten "C-Zustand" bzw. "C-Stage". Durch die Vernetzung des Harzmaterials wird die auf der Harzmaterialschicht angeordnete Leiterbahn fest mit dem Harzmaterial verbunden, gewissermaßen also verklebt.

Die Herstellung einer erfindungsgemäßen flexiblen gedruckten Schaltung umfasst die Schritte, dass (a) wenigstens eine elektrische Leiterbahn auf die Harzmaterialschicht eines ersten flexiblen Schichtsystems der voranstehend beschriebenen Art aufgebracht wird und (b) die Leiterbahn und das Schichtsystem einer Wärme- und/oder Druckbehandlung unterzogen wird, um das Harzmaterial zu vernetzen. Schritt (b) bildet gewissermaßen also einen Laminiervorgang, bei welchem das Harzmaterial aus dem "B-Zustand" in den "C-Zustand" überführt wird und eine Verbindung der Leiterbahn mit dem Harzmaterial erreicht wird.

Gemäß einer Ausführungsform des Verfahrens umfasst Schritt (a) das Aufbringen einer Metallfolie, insbesondere Kupferfolie, auf die Harzmaterialschicht und ein Strukturieren der Metallfolie zum Ausbilden der Leiterbahn. Die Strukturierung der Metallfolie kann dabei in an sich bekannter Weise unter Verwendung geeigneter Maskierungs- und Ätzprozesse erfolgen.

Gemäß einer weiteren Ausführungsform des Verfahrens wird zwischen Schritt (a) und Schritt (b) ein die Leiterbahn überdeckendes zweites flexibles Schichtsystem der voranstehend beschriebenen Art auf das erste flexible Schichtsystem derart aufgebracht, dass die Harzmaterialschichten der flexiblen Schichtsysteme zueinander weisen. Die Leiterbahn wird somit zwischen den Harzmaterialschichten zweier Schichtsysteme eingebettet und durch den in Schritt (b) erfolgenden Laminiervorgang mit beiden Schichtsystemen verbunden.

Alternativ kann zwischen Schritt (a) und Schritt (b) eine die Leiterbahn überdeckende Kunststofffolie auf das erste flexible Schichtsystem aufgebracht werden. Durch den in Schritt (b) erfolgenden Laminiervorgang wird die Leiterbahn folglich mit dem Schichtsystem und der Kunststofffolie verbunden.

Gemäß einer weiteren Ausführungsform wird bereits vor Schritt (a) eine Metallfolie, insbesondere Kupferfolie, auf eine Kunststofffolie aufgebracht und strukturiert, um die Leiterbahn auszubilden. In Schritt (a) wird die auf die Kunststofffolie aufgebrachte und bereits strukturierte Leiterbahn dann zusammen mit der Kunststofffolie auf das Schichtsystem aufgebracht und anschließend in Schritt (b) laminiert.

Nachfolgend wird die Erfindung rein beispielhaft anhand vorteilhafter Ausführungsformen unter Bezugnahme auf die Zeichnung beschrieben. Es zeigen:
- Fig. 1: die Herstellung einer erfindungsgemäßen flexiblen gedruckten Schaltung gemäß einer ersten Ausführungsform; und
- Fig. 2: eine erfindungsgemäße flexible gedruckte Schaltung gemäß einer zweiten Ausführungsform.

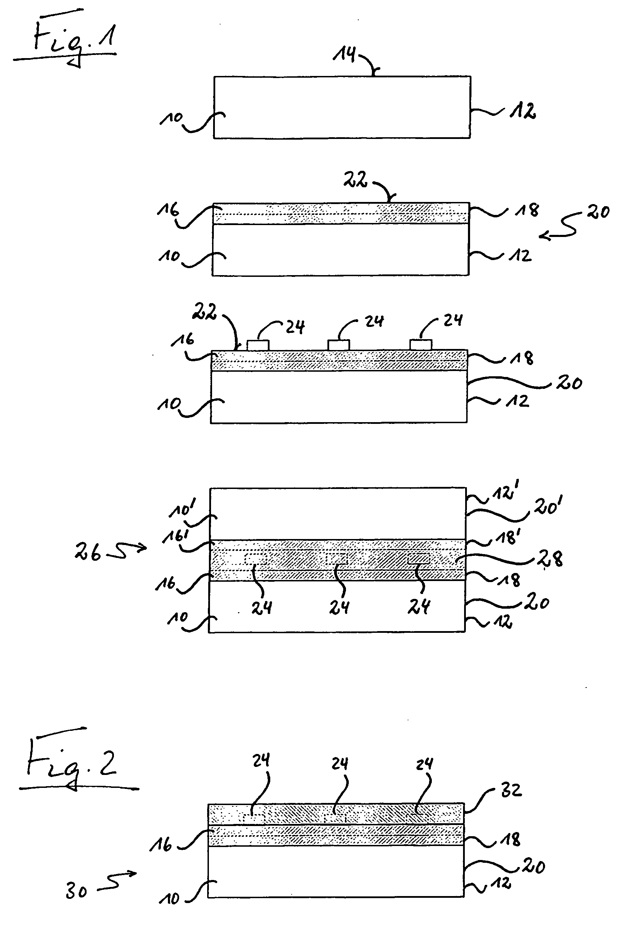

Wie in Fig. 1 dargestellt ist, wird zur Herstellung einer erfindungsgemäßen flexiblen gedruckten Schaltung gemäß einer ersten Ausführungsform zunächst eine ein Gewebematerial 10 aufweisende Gewebematerialschicht 12 bereitgestellt (Fig. la).

Auf eine Oberfläche 14 der Gewebematerialschicht 12 wird eine ein Harzmaterial 16 aufweisende Harzmaterialschicht 18 aufgebracht. Dabei sind das Gewebematerial 10 und das Harzmaterial 16 derart aneinander angepasst, dass das Harzmaterial 16 beim Aufbringen auf die Gewebematerialschicht 12 so wenig wie möglich in das Gewebematerial 10 eindringt. Jedenfalls sollte die Eindringtiefe des Harzmaterials 16 in die Gewebematerialschicht 12 nicht mehr als etwa 80 % der Dicke der Gewebematerialschicht 12 betragen.

Nach dem Aufbringen des Harzmaterials 16 auf die Gewebematerialschicht 12 wird das Harzmaterial 16 physikalisch getrocknet, ohne dass es dabei vernetzt. Das Harzmaterial 16 wird mit anderen Worten aus dem sogenannten "A-Zustand" in den sogenannten "B-Zustand" überführt. Das resultierende Schichtsystem ist in Fig. 1b gezeigt und bildet ein eine Gewebematerialschicht 12 und eine Harzmaterialschicht 18 umfassendes erfindungsgemäßes flexibles Schichtsystem 20, welches sich sowohl durch eine besonders hohe Reißfestigkeit als auch durch eine besonders hohe Flexibilität auszeichnet.

Wie in Fig. 1c dargestellt ist, wird auf die dem Gewebematerial 10 abgewandte Oberseite 22 der Harzmaterialschicht 18 mindestens eine elektrische Leiterbahn 24 aufgebracht. In der Figur sind exemplarisch drei Leiterbahnen 24 dargestellt, die Anzahl der Leiterbahnen 24 kann hiervon aber auch abweichen. Die Herstellung der Leiterbahnen 24 erfolgt z.B. durch Aufbringen einer Kupferfolie auf die Harzmaterialschicht 18 und anschließendes Strukturieren der Kupferfolie mittels geeigneter Maskierungs- und Ätzprozesse.

Zum Schutz der elektrischen Leiterbahnen 24 werden diese anschließend durch eine Deckschicht abgedeckt. Bei dem in Fig. 1 dargestellten Ausführungsbeispiel ist die Deckschicht durch ein zweites flexibles Schichtsystem 20' gebildet, welches derart auf die elektrischen Leiterbahnen 24 aufgesetzt wird, das die Harzmaterialschicht 18' des zweiten Schichtsystems 20' zu der Harzmaterialschicht 18 des ersten Schichtsystems 20 weist.

Anschließend wird dieser "Sandwich" aus erstem Schichtsystem 20, elektrischen Leiterbahnen 24 und zweitem Schichtsystem 20' einer Wärme- und/oder Druckbehandlung, beispielsweise einem Laminierprozess, unterzogen. Während dieses Vorgangs vernetzt das Harzmaterial 16, 16', d.h. es wird aus dem "B-Zustand" in den sogenannten "C-Zustand" überführt. Gleichzeitig verbindet sich das Harzmaterial 16 des ersten Schichtsystems 20 stoffschlüssig mit dem Harzmaterial 16' des zweiten Schichtsystems 20', wodurch eine flexible gedruckte Schaltung 26 mit elektrischen Leiterbahnen 24 geschaffen wird, die zwischen zwei Gewebematerialschichten 12, 12' in einer Harzmateriallage 28 eingebettet sind (Fig. 1d).

In Fig. 2 ist eine zweite Ausführungsform einer erfindungsgemäßen flexiblen Schaltung 30 dargestellt, die sich von der in Fig. 1d gezeigten ersten Ausführungsform lediglich darin unterscheidet, dass die Deckschicht zur Abdeckung der elektrischen Leiterbahnen 24 hier nicht durch ein zweites flexibles Schichtsystem 20', sondern durch eine Kunststofffolie 32 gebildet ist.

Die Herstellung dieser flexiblen gedruckten Schaltung 30 gemäß zweiter Ausführungsform erfolgt zunächst entsprechend den in Fig. 1a bis 1c gezeigten Schritten. Anders als voranstehend beschrieben, wird nach der Ausbildung der elektrischen Leiterbahnen 24 auf dem Schichtsystem 20 jedoch kein zweites Schichtsystem 20', sondern die Kunststofffolie 32 auf die Oberseite 22 des Schichtsystems 20 aufgelegt.

Dieses das Schichtsystem 20, die elektrischen Leiterbahnen 24 und die Kunststofffolie 32 umfassende Gebilde wird anschließend einer Wärme- und/oder Druckbehandlung unterzogen, um das Harzmaterial 16 zu vernetzen und dabei eine stoffschlüssige Verbindung zwischen der Kunststofffolie 32 und dem Harzmaterial 16 zu schaffen.

Alternativ ist es zur Herstellung der in Fig. 2 gezeigten flexiblen gedruckten Schaltung 30 auch möglich, die elektrischen Leiterbahnen 24 zunächst auf der Kunststofffolie 32 auszubilden, indem z.B. eine Kupferfolie auf die Kunststofffolie 32 aufgebracht und durch Maskierungs- und Ätzprozesse strukturiert wird. Die mit den Leiterbahnen 24 versehene Kunststofffolie 32 kann dann auf die Oberseite 22 eines erfindungsgemäßen flexiblen Schichtsystems 20 aufgebracht werden. Wie zuvor kann dieses Gebilde aus Schichtsystem 20, elektrischen Leiterbahnen 24 und Kunststofffolie 32 dann einer Wärme- und/oder Druckbehandlung unterzogen werden, um das Harzmaterial 16 zu vernetzen und stoffschlüssig mit der Kunststofffolie 32 zu verbinden.

### Bezugszeichenliste

- 10: Gewebematerial
- 12: Gewebematerialschicht
- 14: Oberfläche
- 16: Harzmaterial
- 18: Harzmaterialschicht
- 20: Schichtsystem
- 22: Oberseite
- 24: elektrische Leiterbahn
- 26: flexible gedruckte Schaltung
- 28: Harzmateriallage
- 30: flexible gedruckte Schaltung
- 32: Kunststofffolie

## Patentansprüche

1. Flexibles Schichtsystem (20), insbesondere für eine flexible gedruckte Schaltung (26; 30), mit einer ein Gewebematerial (10) aufweisenden Gewebematerialschicht (12) und einer ein Harzmaterial (16) aufweisenden Harzmaterialschicht (18), welche auf eine Oberfläche (14) der Gewebematerialschicht (12) derart aufgebracht ist und in das Gewebematerial (10) derart eindringt, dass die Eindringtiefe des Harzmaterials (16) in das Gewebematerial (10) nicht mehr als 80 % der Dicke der Gewebematerialschicht (12) beträgt.

2. Flexibles Schichtsystem (20) nach Anspruch 1,
**dadurch gekennzeichnet,**
**dass** das Harzmaterial (16) in einem auf das Gewebematerial (10) aufgebrachten Vormontagezustand physikalisch trocken, aber noch nicht vollständig vernetzt ist.

3. Flexibles Schichtsystem (20) nach Anspruch 1 oder 2,
**dadurch gekennzeichnet,**
**dass** das Gewebematerial (10) ein organisches Material aufweist.

4. Flexibles Schichtsystem (20) nach einem vorherigen Ansprüche,
**dadurch gekennzeichnet,**
**dass** das Gewebematerial (10) und insbesondere die Kettenfäden und/oder die Schussfäden des Gewebematerials (10) Fasern aus einem Polymermaterial, z.B. Poly-Ethylen-Terephthalat (PET) oder Poly-Ethylen-Naphthalat (PEN), oder aus Polyester, Glas, Polyacetat, Polyamid, Polyaramid, Polyphenylensulfid, Polyethersulfon, Polyetherimid, Polyimid oder Polyetheretherketon aufweisen bzw. aufweist.

5. Flexibles Schichtsystem (20) nach einem vorherigen Ansprüche,
**dadurch gekennzeichnet,**
**dass** das Harzmaterial (16) Epoxid, Polyurethan, Polyester, Polyether, Acrylat, Silikon, Polyamid, Phenolharz, Melaminharz, Polysulfid, Kautschuk oder Aminoplast aufweist.

6. Flexible gedruckte Schaltung (26; 30) mit mindestens einem ersten flexiblen Schichtsystem (20) nach einem vorherigen Ansprüche und wenigstens einer elektrischen Leiterbahn (24), die auf der Harzmaterialschicht (18) des ersten flexiblen Schichtsystems (20) angeordnet ist.

7. Flexible gedruckte Schaltung (26) nach Anspruch 6,
**dadurch gekennzeichnet,**
**dass** die Leiterbahn (24) zwischen der Harzmaterialschicht (18) des ersten flexiblen Schichtsystems (20) und der Harzmaterialschicht (18') eines zweiten flexiblen Schichtsystems (20') nach einem der Ansprüche 1 bis 5 angeordnet ist.

8. Flexible gedruckte Schaltung (30) nach Anspruch 6,
**dadurch gekennzeichnet,**
**dass** die Leiterbahn (24) zwischen der Harzmaterialschicht (18) des ersten flexiblen Schichtsystems (20) und einer Folie (32), insbesondere einer Kunststofffolie, angeordnet ist.

9. Flexible gedruckte Schaltung (26; 30) nach einem der Ansprüche 6 bis 8,
**dadurch gekennzeichnet,**
**dass** das Harzmaterial (16) physikalisch trocken und zumindest annähernd vollständig vernetzt ist.

10. Verfahren zum Herstellen einer flexiblen gedruckten Schaltung (26; 30), bei dem
(a) wenigstes eine elektrische Leiterbahn (24) auf die Harzmaterialschicht (18) eines ersten flexiblen Schichtsystems (20) nach einem der Ansprüche 1 bis 5 aufgebracht wird, und
(b) die Leiterbahn (24) und das Schichtsystem (20) einer Wärme- und/oder Druckbehandlung unterzogen werden, um das Harzmaterial (16) zu vernetzen.

11. Verfahren nach Anspruch 10,
**dadurch gekennzeichnet,**
**dass** Schritt (a) das Aufbringen einer Metallfolie, insbesondere Kupferfolie, auf die Harzmaterialschicht (18) und das Strukturieren der Metallfolie zum Ausbilden der Leiterbahn (24) umfasst.

12. Verfahren nach Anspruch 10 oder 11,
**dadurch gekennzeichnet,**
**dass** zwischen Schritt (a) und (b) ein die Leiterbahn (24) überdeckendes zweites flexibles Schichtsystem (20') nach einem der Ansprüche 1 bis 5 auf das erste flexible Schichtsystem (20) derart aufgebracht wird, dass die Harzmaterialschichten (18, 18') der flexiblen Schichtsysteme (20, 20') zueinander weisen.

13. Verfahren nach Anspruch 10 oder 11,
**dadurch gekennzeichnet,**
**dass** zwischen Schritt (a) und (b) eine die Leiterbahn (24) überdeckende Kunststofffolie (32) auf das erste flexible Schichtsystem (20) aufgebracht wird.

14. Verfahren nach Anspruch 10,
**dadurch gekennzeichnet,**
**dass** vor Schritt (a) eine Metallfolie, insbesondere Kupferfolie, auf eine Kunststofffolie (32) aufgebracht und strukturiert wird, um die Leiterbahn (24) auszubilden.

## Claims

1. Flexible layer system (20), in particular for a flexible printed circuit (26; 30), having a layer of woven material (12) comprising a woven material (10), and a layer of resin material (18) which comprises a resin material (16) and which is applied to a surface (14) of the layer of woven material (12) in such a way and penetrates into the woven material (10) in such a way that the depth of penetration of the resin material (16) into the woven material (10) is not more than 80% of the thickness of the layer of woven material (12).

2. Flexible layer system (20) according to claim 1, **characterised in that** the resin material (16) in a preassembled state applied to the woven material (10) is physically dry, but not yet fully crosslinked.

3. Flexible layer system (20) according to claim 1 or 2, **characterised in that** the woven material (10) comprises an organic material.

4. Flexible layer system (20) according to any of the preceding claims, **characterised in that** the woven material (10) and in particular the warp threads and/or the weft threads of the woven material (10) comprises or comprise fibres made from a polymer material, e.g. polyethylene terephthalate (PET) or polyethylene naphthalate (PEN), or from polyester, glass, polyacetate, polyamide, polyaramide, polyphenylene sulphide, polyether sulphone, polyetherimide, polyimide or polyether ether ketone.

5. Flexible layer system (20) according to any of the preceding claims, **characterised in that** the resin material (16) comprises epoxy, polyurethane, polyester, polyether, acrylate, silicone, polyamide, phenolic resin, melamine resin, polysulphide, rubber or aminoplast.

6. Flexible printed circuit (26; 30) having at least one first flexible layer system (20) according to any of the preceding claims and at least one electrical strip conductor (24) which is arranged on the layer of resin material (18) of the first flexible layer system (20).

7. Flexible printed circuit (26) according to claim 6, **characterised in that** the strip conductor (24) is arranged between the layer of resin material (18) of the first flexible layer system (20) and the layer of resin material (18') of a second flexible layer system (20') according to any of claims 1 to 5.

8. Flexible printed circuit (30) according to claim 6, **characterised in that** the strip conductor (24) is arranged between the layer of resin material (18) of the first flexible layer system (20) and a film (32), in particular a plastic film.

9. Flexible printed circuit (26; 30) according to any of claims 6 to 8, **characterised in that** the resin material (16) is physically dry and at least approximately fully crosslinked.

10. Method for manufacturing a flexible printed circuit (26; 30), in which
(a) at least one electrical strip conductor (24) is applied to the layer of resin material (18) of a first flexible layer system (20) according to any of claims 1 to 5, and
(b) the strip conductor (24) and the layer system (20) are subjected to a heat and/or pressure treatment in order to crosslink the resin material (16).

11. Method according to claim 10, **characterised in that** step (a) includes applying a metal foil, in particular copper foil, to the layer of resin material (18), and structuring the metal foil to form the strip conductor (24).

12. Method according to claim 10 or 11, **characterised in that** between steps (a) and (b) a second flexible layer system (20') according to any of claims 1 to 5 covering the strip conductor (24) is applied to the first flexible layer system (20) in such a way that the layers of resin material (18, 18') of the flexible layer systems (20, 20') face towards each other.

13. Method according to claim 10 or 11, **characterised in that** between steps (a) and (b) a plastic film (32) covering the strip conductor (24) is applied to the first flexible layer system (20).

14. Method according to claim 10, **characterised in that** before step (a) a metal foil, in particular copper foil, is applied to a plastic film (32) and structured to form the strip conductor (24).

## Revendications

1. Système à couches souple (20), en particulier pour un circuit imprimé souple (26 ; 30), comprenant une couche en matériau textile (12) présentant un matériau textile (10) et une couche en matériau résineux (18) présentant un matériau résineux (16), laquelle est appliquée sur une surface (14) de la couche en matériau textile (12) d'une manière telle et pénètre dans le matériau textile (10) de telle façon que la profondeur de pénétration du matériau résineux (16) dans le matériau textile (10) ne dépasse pas 80 % de l'épaisseur de la couche en matériau textile (12).

2. Système à couches souple (20) selon la revendication 1,
**caractérisé en ce que** le matériau résineux (16), dans une situation de montage préliminaire appliqué sur le matériau textile (10), est sec sur le plan physique mais n'est pas encore totalement réticulé.

3. Système à couches souple (20) selon la revendication 1 ou 2,
**caractérisé en ce que** le matériau textile (10) comporte un matériau organique.

4. Système à couches souple (20) selon l'une des revendications précédentes,
**caractérisé en ce que** le matériau textile (10) et en particulier les fils de chaîne et/ou les fils de trame du matériau textile (10) comporte(nt) des fibres d'un matériau polymère, par exemple polyéthylène téréphtalate (PET) ou polyéthylène naphtalate (PEN) ou polyester, verre, polyacétal, polyamide, polyaramide, polyphénylène sulfide, polyéther sulfone, polyétherimide, polyimide ou polyétheréthercétone.

5. Système à couches souple (20) selon l'une des revendications précédentes,
**caractérisé en ce que** le matériau résineux (16) comprend époxyde, polyuréthane, polyester, polyéther, acrylate, silicone, polyamide, résine phénolique, résine mélamine, polysulfide, caoutchouc ou aminoplaste.

6. Circuit imprimé souple (26 ; 30) comprenant au moins un premier système à couches souple (20) selon l'une des revendications précédentes et au moins une piste électrique conductrice (24), laquelle est agencée sur la couche en matériau résineux (18) du premier système à couches souple (20).

7. Circuit imprimé souple (26) selon la revendication 6,
**caractérisé en ce que** la piste conductrice (24) est agencée entre la couche en matériau résineux (18) du premier système à couches souple (20) et la couche en matériau résineux (18') d'un second système à couches souple (20') selon l'une des revendications 1 à 5.

8. Circuit imprimé souple (30) selon la revendication 6,
**caractérisé en ce que** la piste conductrice (24) est agencée entre la couche en matériau résineux (18) du premier système à couches souple (20) et un film (32), en particulier un film en matière plastique.

9. Circuit imprimé souple (26 ; 30) selon l'une des revendications 6 à 8,
**caractérisé en ce que** le matériau résineux est sec sur le plan physique et au moins pratiquement totalement réticulé.

10. Procédé pour la réalisation d'un circuit imprimé souple (26 ; 30), dans lequel :
(a) au moins une piste électrique conductrice (24) est appliquée sur la couche en matériau résineux (18) d'un premier système à couches souple (20) selon l'une des revendications 1 à 5, et
(b) la piste conductrice (24) et le système à couches (20) sont soumis à un traitement à chaud et/ou sous pression, pour faire réticuler le matériau résineux (16).

11. Procédé selon la revendication 10,
**caractérisé en ce que** l'étape (a) inclut l'application d'un film métallique, en particulier d'un film de cuivre, sur la couche en matériau résineux (18), et la structuration du film métallique pour réaliser la piste conductrice (24).

12. Procédé selon la revendication 10 ou 11,
**caractérisé en ce que**, entre les étapes (a) et (b), un second système à couches souple (20') selon l'une des revendications 1 à 5, qui recouvre la piste conductrice (24), est appliqué sur le premier système à couches souple (20) de telle manière que les couches en matériau résineux (18, 18') des systèmes à couches souple (20, 20') sont tournées l'une vers l'autre.

13. Procédé selon la revendication 10 ou 11,
**caractérisé en ce que**, entre les étapes (a) et (b), un film en matière plastique (32) qui recouvre la piste conductrice (24) est appliqué sur le premier système à couches souple (20).

14. Procédé selon la revendication 10,
**caractérisé en ce qu'**avant l'étape (a) un film en métal, en particulier un film en cuivre, est appliqué sur un film en matière plastique (32) et structuré afin de réaliser la piste conductrice (24).
